# EUROPÄISCHE PATENTSCHRIFT

(11) **EP 2 106 458 B1**
(45) Veröffentlichungstag und Bekanntmachung des Hinweises auf die Patenterteilung: **18.09.2013**
(21) Anmeldenummer: 07847343.6
(22) Anmeldetag: 26.11.2007
(51) Int. Cl.: C23C 14/50, C23C 14/56

(54) **BESCHICHTUNGSANLAGE MIT EINER FUNKVORRICHTUNG SOWIE VERFAHREN ZUR STEUERUNG EINES AKTORS BZW. EINER HEIZUNG**
COATING INSTALLATION COMPRISING A RADIO DEVICE AND METHOD FOR CONTROLLING AN ACTUATOR OR A HEATER
INSTALLATION D'APPLICATION DE REVÊTEMENT ÉQUIPÉE D'UN DISPOSITIF RADIO ET PROCÉDÉ POUR COMMANDER UN ACTIONNEUR OU UN SYSTÈME DE CHAUFFAGE

(30) Priorität: 29.11.2006 DE 102006056289
(43) Veröffentlichungstag der Anmeldung: 07.10.2009
(73) Patentinhaber: Leica Microsystems CMS GmbH, 35578 Wetzlar (DE); BANKMANN, Joachim, 37115 Duderstadt (DE)
(72) Erfinder: BANKMANN, Joachim, 37115 Duderstadt (DE); EISENKRÄMER, Frank, 35444 Biebertal (DE)
(74) Vertreter: Schaumburg, Thoenes, Thurn, Landskron, Eckert
(86) Internationale Anmeldenummer: PCT/EP2007/062810
(87) Internationale Veröffentlichungsnummer: WO 2008/065073

(56) Entgegenhaltungen:
- GB-A- 2 421 738
- JP-A- 9 256 155
- US-A1- 2002 148 307
- US-A1- 2003 209 097
- HIEBER K: "A novel technique for in situ measurements of thin film properties" THIN SOLID FILMS SWITZERLAND, Bd. 130, Nr. 1-2, 16. August 1985 (1985-08-16), Seiten 125-134, XP002472651 ISSN: 0040-6090

## Beschreibung

Die Erfindung bezieht sich auf eine Beschichtungsanlage mit einer Beschichtungskammer und einem innerhalb der Beschichtungskammer bewegbar angeordneten Substrathalter, der zur Aufnahme von zu beschichtenden Substraten geeignet ist. Eine solche Beschichtungsanlage geht aus der EP 1 050 597 B1 hervor.

Dünne Schichten mit ihren vielfältigen Eigenschaften und Funktionen nehmen eine bedeutende Rolle im modernen Alltag ein. Insbesondere dünne Schichten mit einer optischen Funktion, z.B. Spiegelschichten, Filterschichten oder Antireflektionsschichten gewinnen zunehmend an Bedeutung. Dabei sind sowohl Einzelschichten, als auch eine Abfolge von mehreren aufeinander abgeschiedenen Schichten, so genannte Schichtpakete, von Interesse. Dünne Schichten und Schichtpakete lassen sich in Beschichtungsanlagen auf geeigneten Substraten, wie z.B. Glas, Keramik oder Kunststoff, herstellen. Hierzu verfügt eine Beschichtungsanlage zumindest über eine Beschichtungskammer in der sowohl ein zur Aufnahme eines oder mehrerer Substrate geeigneter Substrathalter und eine Materialquelle angeordnet sind. Typischerweise erfolgt die Beschichtung der Substrate in einer evakuierten Beschichtungskammer. Die Herstellung dünner Schichten kann aber ebenfalls in einer Gasatmosphäre unter einem gezielt wählbaren Gasdruck erfolgen.

Der Substrathalter einer Beschichtungsanlage ist vielfach derart in der Beschichtungskammer angeordnet, dass eine Bewegung, vorzugsweise eine Rotation des Substrathalters zu einer Bewegung des bzw. der Substrate(s) in dem von der Materialquelle abgegebenen Partikelstrom führt. Durch eine gezielte Bewegung des Substrates oder mehrerer Substrate in oder durch den Partikelstrom der Materialquelle kann eine definierte Beschichtung der Substrate erreicht werden. Eine Beschichtungsanlage mit einer wechselbaren Drehkalotte als Substrathalter geht aus der EP 1 050 597 B1 hervor. Diese Beschichtungsanlage ist insbesondere zur Beschichtung von Kunststoffbrillengläsern geeignet.

Zur Qualitätssicherung der Produktion ist es wünschenswert, nach Möglichkeit schon während des Depositionsprozesses verschiedene charakteristische Parameter der aufgebrachten Schichten zu messen. Bei einer solchen Messung sind unter anderem optische Parameter der Schichten und/oder die Schichtdicke von Interesse.

DE 3610733 A1 offenbart eine Vorrichtung zur Messung der optischen Eigenschaften dünner Schichten während ihres Aufbaus. Insbesondere wird das Transmissionsverhalten optischer Schichten gemessen, während die zu vermessende Schicht in einer Vakuumkammer deponiert wird. Die zu vermessende Schicht wird auf ein bewegtes Substrat aufgebracht, welches vorzugsweise gleichmäßig auf einer Kreisbahn bewegt wird. Die Messung erfolgt mittels eines gegenüber der Vakuumkammer ortsfesten Messlichtstrahls. Dieser ermöglicht es, gemäß der gleichmäßigen Kreisbewegung des Substrates, jeweils für einen Bruchteil der Kreisbewegung ein für die aufgebrachte Schicht charakteristisches Messsignal aufzunehmen. Das in DE 3610733 A1 offenbarte Messkonzept steht jedoch Messungen, welche typischerweise über einen längeren Zeitraum erfolgen sollten, nicht offen. Die technischen Probleme hinsichtlich der Aufnahme solcher Messdaten vergrößern sich bei zunehmender Geschwindigkeit mit der die zu vermessenden Substrate innerhalb der Vakuumkammer bewegt werden. Weiterhin ist es mit dem vorgenannten Messkonzept nicht möglich, Messdaten von Schichten zu erlangen, die nicht periodisch oder mit sehr langen Periodenlängen in einer Vakuumkammer bewegt werden.

DE 4314251 A1 offenbart ein Verfahren sowie eine Vorrichtung zur Herstellung optisch absorbierender dünner Schichten. Gemäß der vorstehenden Druckschrift, wird ein ortsfest in der Vakuumkammer einer Beschichtungsanlage angebrachtes Testsubstrat hinsichtlich seiner optischen Eigenschaften vermessen. Die Messung erfolgt über einen gegenüber der Vakuumkammer ortsfesten Messlichtstrahl. Anhand der an dem Testsubstrat, bzw. der auf diesem Testsubstrat aufgebrachten dünnen Schicht, gemessenen Werte, werden Rückschlüsse auf die Eigenschaften derjenigen Schichten gezogen, die auf die innerhalb der Vakuumkammer rotierenden Substrate abgeschieden werden. Es handelt sich in diesem Fall also um ein indirektes Messverfahren. Solche Verfahren weisen typischerweise unkalkulierbare Messungenauigkeiten auf.

Nicht nur die optischen Eigenschaften von dünnen Schichten sind von Interesse, auch die Substrattemperatur stellt eine wichtige physikalische Größe bei der Herstellung dünner Schichten dar. Typischerweise wird die Temperatur in einer Beschichtungskammer mit einem ortsfest in der Beschichtungskammer angeordneten Thermoelement gemessen. Die eigentliche Temperatur der Substrate wird anhand dieses Wertes abgeschätzt.

EP 1 050 598 B1 offenbart eine Vakuumbeschichtungsanlage in der ein Temperaturfühler mit den Trägermitteln der zu beschichtenden Substrate umläuft. Auf diese Weise kann die Temperatur in der Beschichtungsebene erfasst werden. Die in EP 1 050 598 B1 offenbarte Einrichtung zur Temperaturmessung besteht aus einem ersten Teil, der mit dem stationären Teil der Beschichtungsanlage verbundenen ist, und einem zweiten Teil, der mit der sich drehenden Kalotte, dem Trägermittel für die zu beschichtenden Substrate, verbunden ist. Der erste und zweite Teil sind induktiv miteinander gekoppelt. Für eine effektive Kopplung der Primär- und Sekundärspule, die jeweils ein Bestandteil des feststehenden ersten bzw. des beweglichen zweiten Teils der Einrichtung zur Temperaturmessung sind, ist es notwendig, dass die Primär- und Sekundärspule koaxial und zueinander umlaufend angeordnet sind. Wie unmittelbar ersichtlich ist die vorgenannte Einrichtung zur Temperaturmessung technisch aufwändig, denn sie erfordert eine konzentrisch zueinander angeordnete Primär- und Sekundärspule welche zudem vorzugsweise nahe der Drehachse der Kalotte anzuordnen sind. Weiterhin ist die in EP1 050 598 B1 offenbarte Einrichtung für eine Temperaturmessung lediglich für um eine einzelne Achse drehbar gelagerte Substrathalter verwendbar. Die zuvor beschriebene Einrichtung zur Temperaturmessung ist demnach z.B. nicht für Vakuumbeschichtungsanlagen geeignet, in denen der Substrathalter mit einem Planetengetriebe angetrieben wird, oder in denen der Substrathalter um mehr als eine Achse drehbar gelagert ist.

US 4 860 687 offenbart eine Beschichtungsanlage mit einem drehbaren Substrathalter. Der drehbare Substrathalter wird in einer Beschichtungskammer unter Verzicht auf eine oder mehrere mechanische Drehdurchführungen mittels eines Gasstromes getragen und in Drehung versetzt. Die Gaszufuhr erfolgt von der Unterseite des Substrathalters, auf der Oberseite des Substrathalters befinden sich die zu beschichtenden Substrate. Auch für die zuvor beschriebe Beschichtungsanlage kann der Wunsch bestehen, die Substrattemperatur in der Substratebene zu messen. Offensichtlich ist aber die in EP 1 050 598 offenbarte Technik nicht auf ein System wie es in US 4 860 687 offenbart ist anwendbar.

Neben der Möglichkeit die Substrate bereits während des Herstellungsprozesses zu charakterisieren besteht weiterhin der Wunsch die Substrate gezielt und bereits während des Herstellungsprozesses zu manipulieren. Typischerweise erfolgt die mechanische Manipulation von Substraten oder dem Substrathalter mittels Schiebe- und/oder Drehdurchführungen. Eine Manipulation der Substrate mittels einer Heizung kann für bewegte Substrate lediglich indirekt über eine ortsfest in der Beschichtungskammer montierte Heizung erfolgen. Befindet sich das zu beschichtende Substrat auf einem bewegten Substrathalter, scheiden direkte mechanische Manipulationsmöglichkeiten, sowie eine direkte Heizung der Substrate praktisch aus.

In einer Beschichtungsanlage werden die zu beschichtenden Substrate typischerweise lediglich von einer Seite beschichtet. Indem die Substrate in der Beschichtungskammer um 180° gedreht werden, besteht theoretisch die Möglichkeit in einem einzelnen Beschichtungszyklus die doppelte Anzahl an Flächen zu beschichten.

DE 37 15831 A1 offenbart eine Vakuumbeschichtungsanlage mit einem kalottenförmigen Substrathalter, der aus einzelnen drehbaren Trägerplatten besteht. Um die Trägerplatten wenden zu können sind diese an ihrer Drehachse mit einem Wendesteuerkurvenmittel in Form einer Umstellgabel verbunden. Diese Umstellgabel wirkt mit einem Stellstift, der temporär in den Umlaufbereich der Trägerplatte fahrbar ist, zusammen, und bewirkt so die Drehung der Trägerplatte. Eine Beschichtungsanlage mit den in DE 37 15831 A1 offenbarten Substratträgermitteln ist offensichtlich technisch aufwändig, da ein sensibles Zusammenwirken von Stellstift und Umstellgabel notwenig für die Funktionsfähigkeit des Wendemechanismus ist. Weiterhin ist die Lage der Drehachse um die die Trägerplatten wendbar sind nicht frei wählbar, sie ist offensichtlich von der Lage der Trägerplatten in dem kalottenförmigen Substrathalter abhängig.

In der JP 09 256155 A ist eine Beschichtungsanlage mit einer Vakuumkammer beschrieben, bei der ein innerhalb der Vakuumkammer angeordneter Sender mittels einer Funkverbindung zu einem außerhalb der Vakuumkammer angeordneten Sender Informationen übermittelt.

Die US 2002/0148307 A1 offenbart eine Vakuumkammer mit mehreren kabellosen Sensoren zum Überwachen eines in dieser Vakuumkammer ablaufenden Fertigungsprozesses. Die Datenübertragung erfolgt mittels Funksignalen auf einer ISM-Frequenz, beispielsweise nach dem Bluetooth-Standard.

Aus der GB-A-2 421 738 ist eine Vorrichtung zum Erzeugen einer dünnen Schicht auf einem Trägermaterial in einem Ultrahoch-Vakuum bekannt. Das Trägermaterial ist an einem Substrathalter befestigt, der ein Planetengetriebe umfassen kann. Die Vorrichtung umfasst einen mit einem Funkgerät verbundenen Sensor zur Prozessüberwachung, wobei die vom Sensor erfassten Daten drahtlos per Funk übertragen werden.

Aufgabe der vorliegenden Erfindung ist es, eine Beschichtungsanlage anzugeben welche mit Mitteln ausgestattet ist, die es erlauben auf einfache und flexible Weise zum einen Informationen von einem Ort innerhalb der Beschichtungskammer an einen Ort außerhalb der Beschichtungskammer zu kommunizieren und zum anderen Befehle von einem Ort außerhalb an einen Ort innerhalb der Beschichtungskammer zu kommunizieren.

Diese Aufgabe wird vorrichtungsbezogen mit den in Anspruch 1 angegebenen Maßnahmen gelöst. Verfahrensbezogen wird die Aufgabe mit den in Anspruch 12 und 13 angegebenen Maßnahmen gelöst. Der Erfindung liegt dabei die Überlegung zugrunde, entgegen denen aus dem Stand der Technik bekannten Lösungen, eine Funkverbindung zu nutzen, um zum einen innerhalb einer Beschichtungskammer gewonnene Daten und Informationen an einen Ort außerhalb dieser Beschichtungskammer zu übertragen, und zum anderen Befehle/Kommandos von einem Ort außerhalb der Beschichtungskammer an einen Ort innerhalb der Beschichtungskammer zu kommunizieren.

Erfindungsgemäß soll eine Beschichtungsanlage mit einer Beschichtungskammer und mindestens einem innerhalb der Beschichtungskammer bewegbar angeordneten Substrathalter zur Aufnahme von zu beschichtenden Substraten angegeben werden. Die Beschichtungskammer soll weiterhin eine Funkvorrichtung umfassen, die aus mindestens zwei Funkgeräten besteht, wobei zumindest ein erstes Funkgerät mit dem Substrathalter verbunden ist, und zumindest ein zweites Funkgerät zumindest teilweise außerhalb der Beschichtungskammer angeordnet ist. Zwischen den Funkgeräten soll zumindest zeitweise eine Funkverbindung zur Übertragung von Informationen zwischen dem ersten und dem zweiten Funkgerät bestehen.

Die mit der vorgenannten Ausgestaltung der Beschichtungsanlage verbundenen Vorteile sind insbesondere darin zu sehen, dass es mittels einer Funkvorrichtung möglich ist, unabhängig von der Bewegung des Substrathalters, Informationen zwischen einem Ort innerhalb und außerhalb der Beschichtungskammer auszutauschen. Mittels der erfindungsgemäßen Ausgestaltung der Beschichtungsanlage ist es möglich die technischen Probleme einer drahtgebundenen Übertragung von Informationen zu überwinden. So kann ein innerhalb der Beschichtungskammer angebrachtes Kabel zur Übertragung von Informationen die Bewegung des Substrathalters beeinflussen, oder der sich bewegende Substrathalter könnte das Übertragungskabel beschädigen. Wird der Substrathalter in der Beschichtungskammer gedreht, so wäre die Verwendung von Schleifkontakten möglich, um Informationen drahtgebunden zu übertragen. Schleifkontakte weisen jedoch eine geringe Zuverlässigkeit auf. Wird ein Schleifkontakt in einer Beschichtungsanlage verwendet, so wird seine Zuverlässigkeit, bedingt durch das in der Beschichtungskammer deponierte Material, zusätzlich verschlechtert.

Es besteht die Möglichkeit mit Hilfe einer Vorrichtung welche zwei induktiv miteinander gekoppelte Spulen umfasst drahtlos Energie zwischen einem sich drehenden Substrathalter und einem festen Punkt innerhalb einer Beschichtungskammer auszutauschen. Eine solche Lösung ist jedoch lediglich für solche Beschichtungsanlagen geeignet, in denen ein Substrathalter in einer gleichmäßigen Bewegung um eine feste Achse gedreht wird. Beide Spulenpaare einer solchen Vorrichtung sind innerhalb der Beschichtungskammer angeordnet. Aus diesem Grund weist eine solche Vorrichtung zumindest die gleichen technischen Probleme, bedingt durch in der Beschichtungskammer deponiertes Material auf wie z.B. Schleifkontakte.

Vorteilhafte Ausgestaltungen der erfindungsgemäßen Beschichtungsanlage gehen aus den von Anspruch 1 abhängigen Ansprüchen hervor. Dabei kann die Ausführungsform nach Anspruch 1 mit den Merkmalen eines Unteranspruches oder auch vorzugsweise mit denen aus mehreren Unteransprüchen kombiniert werden. Demgemäß kann die Beschichtungsanlage zusätzlich noch folgende Merkmale aufweisen:
- Mit dem ersten Funkgerät kann ein Aktor verbunden sein, welcher in Wirkverbindung mit dem ersten Funkgerät steht und mit dem Substrathalter verbunden ist. Die über die Funkverbindung übertragenen Informationen können weiterhin Steuerbefehle für den Aktor enthalten. Mittels der vorstehenden Ausgestaltungsform der Beschichtungsanlage kann eine gezielte Manipulation einzelner auf dem Substrathalter befindlicher Teile erfolgen. So können z.B. verschiedene Linear- oder Drehbewegungen mit einem oder mehreren Substraten ausgeführt werden. Ebenfalls vorteilhaft können Kräfte auf verschiedene Teile des Substrathalters oder mit diesem verbundenen Teile ausgeübt werden.
- Der Aktor kann mindestens eine mit dem Substrathalter verbundene Blende zur Unterbrechung eines Materialstroms, der von einer innerhalb der Beschichtungskammer angeordneten Materialquelle ausgeht, steuern. Vorteilhaft kann mit Hilfe einer mit dem Substrathalter verbundenen Blende der Materialstrom für ein einzelnes Substrat oder eine Gruppe von Substraten unterbrochen werden. Auf diese Weise können unterschiedliche Schichtdicken oder Schichtabfolgen auf Substraten in einem Beschichtungsgang mit ein und demselben Substrathalter hergestellt werden.
- Der Aktor kann eine Drehung mindestens eines Substrates bewirken. Vorteilhaft kann ein einzelnes Substrat oder eine Gruppe von Substraten während des laufenden Beschichtungsprozesses gedreht werden; so kann eine individuelle Beschichtung für ein einzelnes Substrat oder eine Gruppe von Substraten erreicht werden. Ein einzelnes Substrat oder eine Gruppe von Substraten kann während eines Beschichtungsprozesses typischerweise lediglich von einer Seite beschichtet werden. Wird das Substrat bzw. die Substrate während der Beschichtung gedreht, kann eine Beschichtung von mehreren Seiten erreicht werden.
- Zumindest Teile des Substrathalters können mittels des Aktors um annähernd 180° drehbar sein. Vorteilhaft können durch eine 18 0° - Drehung von zumindest Teilen des Substrathalters die von diesem Teil des Substrathalters getragenen Substrate in einem einzelnen Herstellungsprozess auf gegenüberliegenden Seiten beschichtet werden.
- Zumindest Teile des Substrathalters können um eine Achse drehbar sein, und achsfrei mittels mindestens einer im wesentlichen koaxial zu der Achse gedrehten Feder gegenüber einem Bezugsrahmen abgestützt sein. Vorteilhaft kann durch die vorbeschriebene Halterung von zumindest Teilen des Substrathalters die Zuverlässigkeit des Substrathalters in Bezug auf die freie und ungestörte Drehbarkeit von zumindest Teilen des Substrathalters verbessert werden. Eine achsfreie Aufhängung von zumindest Teilen des Substrathalters verringert die Probleme, die in Beschichtungsanlagen auftreten können wenn ein Lager oder Ähnliches einem Materialstrom ausgesetzt ist. Durch sich an oder in dem Lager absetzendes Material kann die freie Drehbarkeit eingeschränkt werden.
- Zumindest Teile des Substrathalters können mittels der mindestens einen gedrehten Feder gegenüber dem Bezugsrahmen unter Vorspannung stehen. Die 180° - Drehung von zumindest Teilen des Substrathalters kann unter Abbau der Vorspannung der mindestens einen gedrehten Feder erfolgen. Vorteilhaft können durch die zuvor beschriebene Ausgestaltung von zumindest Teilen des Substrathalters diese einfach und effektiv gedreht werden. Beispielsweise kann die Funktion des Aktors lediglich in einer Freigabe der Drehbewegung bestehen, wodurch der Aktor einfach und kostengünstig ausgestaltet sein kann.
- Mit dem ersten Funkgerät kann mindestens eine Heizung verbunden sein, die in Wirkverbindung mit dem ersten Funkgerät steht und mit dem Substrathalter verbunden ist. Ferner können die zwischen den Funkgeräten übertragenen Informationen Steuerbefehle für die Heizung enthalten. In einer Beschichtungsanlage gemäß dem vorstehenden Ausführungsbeispiel kann mit Hilfe der mit dem Substrathalter verbundenen Heizung ein einzelnes oder eine Gruppe von Substraten auf eine gewünschte Temperatur erwärmt werden. Vorteilhaft kann durch direkte Heizung des bzw. der Substrate ihre Temperatur genauer eingestellt werden, als dies mit einer indirekten Heizung möglich ist.
- Das erste Funkgerät kann außer mit einem Aktor und/oder einer Heizung zusätzlich mit einem Messgerät verbunden sein. Eine Beschichtungsanlage gemäß der vorstehenden Ausführungsform erlaubt eine Steuerung des Aktors und/oder der Heizung basierend auf den Messergebnissen des Messgerätes. Vorteilhaft kann so der Aktor und/oder die Heizung in einem rückgekoppelten Steuerkreis, basierend auf den Messergebnissen des Messgerätes, gesteuert werden.
- Das Messgerät kann zur Messung mindestens einer physikalischen Größe aus einer Gruppe von physikalischen Größen, bestehend aus einer Substrattemperatur, einem Gasdruck, einer elektrischen Spannung, einem elektrischen Widerstand oder einer Schichtdicke einer auf einem zu beschichtenden Substrat abgeschiedenen Schicht, geeignet sein. Weiterhin kann mindestens eine dieser physikalischen Größen ein Steuerparameter des Aktors und/oder der Heizung sein. Die vorgenannten physikalischen Größen stellen wichtige Prozessparameter bei der Herstellung dünner Schichten dar. Eine Messung derartiger physikalischer Größen an einem bewegten Substrat bzw. der auf dem bewegten Substrat befindlichen dünnen Schicht, ist mittels konventioneller kontaktloser Messverfahren nicht möglich. Vorteilhaft kann gemäß der vorbeschriebenen Ausgestaltung der Beschichtungsanlage eine besonders effektive, einfache und kostengünstige Art für derartige Messungen angegeben werden. Weiterhin vorteilhaft kann der Aktor und/oder die Heizung basierend auf einem oder mehreren dieser physikalischen Größen gesteuert werden.
- Das erste Funkgerät, der Aktor und/oder das Messgerät können mit Mitteln zur thermischen Isolation ausgestattet sein. Zur gezielten Herstellung bestimmter Schichten können in der Beschichtungskammer einer Beschichtungsanlage Temperaturen herrschen, die oberhalb einer kritischen Temperatur liegen, ab welcher elektronische Schaltungen typischerweise dauerhaft Schaden nehmen. Durch eine thermische Isolation des ersten Funkgerätes, des Aktors und/oder des Messgerätes kann deren Zuverlässigkeit bei einem Einsatz innerhalb einer wie zuvor beschriebenen Beschichtungskammer verbessert werden.
- Das erste Funkgerät, der Aktor und/oder das Messgerät können in einem vakuumisolierten Gehäuse untergebracht sein. Bei der Herstellung dünner Schichten kann die Notwendigkeit entstehen, die Beschichtungskammer zu evakuieren. Durch eine Vakuumisolation kann zum einen die Elektronik des Messgerätes, des Aktors und/oder des Funkgerätes vor dem Vakuum geschützt werden, z.B. kann einem Ausgasen bestimmter Bauteile vorgebeugt werden. Zum anderen kann das in der Beschichtungskammer herrschende Isoliervakuum vor ungewünschten Verunreinigungen, welche durch ein Ausgasen elektronischer Bauteile hervorgerufen werden können, geschützt werden.
- Das erste Funkgerät, der Aktor und/oder das Messgerät können in einem gemeinsamen Gehäuse untergebracht sein. Besonders vorteilhaft kann, indem das Funkgerät, der Aktor und/oder das Messgerät in einem gemeinsamen Gehäuse untergebracht werden, der technische Aufwand für die Integration der entsprechenden Bauteile in die Beschichtungskammer verringert werden.
- Der Substrathalter kann um eine festgelegte Achse drehbar sein, und als Kalotte ausgestaltet sein. Durch eine Ausgestaltung des Substrathalters in Form einer Kalotte kann eine homogene Beschichtung der von der Kalotte getragenen Substrate erreicht werden. Für die auf diese Weise hergestellten homogenen und somit hochwertigen dünnen Schichten ist es besonders interessant z.B. Messwerte zur Charakterisierung der Schichten zu gewinnen. Weiterhin vorteilhaft können in einer Beschichtungsanlage gemäß dem vorstehenden Ausführungsbeispiel die Substrate beispielsweise geheizt werden.
- In der Beschichtungskammer kann ein um eine festgelegte Achse drehbares Planetengetriebe angeordnet sein. Das Planetengetriebe kann weiterhin dazu geeignet sein, mindestens einen Substrathalter in eine Drehung um eine, zu der Achse des Planetengetriebes, parallelen Achse zu versetzen. Planetengetriebe erlauben es, die auf dem/den Substrathalter/n angebrachten Substrate in eine Bewegung mit einer sehr lagen Periode zu versetzen. D.h. die Substrate gelangen erst nach einer sehr langen Zeit zum wiederholten Mal an denselben Ort in der Beschichtungskammer. Auf diese Weise kann eine sehr homogene Beschichtung der Substrate erreicht werden. Das auf dem Substrathalter angebrachte Messgerät erlaubt es, Messwerte an den auf die vorbeschriebene Weise hergestellten Schichten aufzunehmen. Weiterhin erlaubt ein Aktor z.B. eine Drehung eines oder mehrerer Substrat/e und eine Heizung die Erwärmung derselben. Besonders vorteilhaft können durch den Einsatz einer Funkverbindung zu Messwertübertragung und/oder zur Steuerung eines Aktors und/oder einer Heizung die Probleme einer drahtgebundenen Messwertübertragung von sich nahezu unregelmäßig bewegenden Substraten überwunden werden.
- Die Trägerfrequenz der Funkverbindung kann eine ISM - Frequenz (Industrial Scientific and Medical) sein. Vorzugsweise kann die Trägerfrequenz 27 MHz, 40 MHz, 446 MHz, 860 MHz oder 2,45 GHz betragen. Weiterhin kann die Funkverbindung eine digitale Funkverbindung sein. Vorteilhaft kann für die Funkverbindung eine ISM - Frequenz verwendet werden, da diese Frequenzen anmelde- und gebührenfrei verwendet werden können. Eine Störung anderer elektronischer Bauteile der Beschichtungsanlage kann ebenfalls weitgehend vermieden werden. Eine digitale Funkverbindung erlaubt weiterhin eine verbesserte Fehlerkorrektur und wirkt sich somit vorteilhaft auf die Zuverlässigkeit der Informationsübertragung aus.
- Die Beschichtungskammer kann auf ein Hoch- oder Ultrahochvakuum evakuierbar sein. Zur Herstellung hochwertiger dünner Schichten wird ein geeignetes Isoliervakuum benötigt. Typischerweise ist ein solches Isoliervakuum ein Hoch- oder Ultrahochvakuum. Die Messung physikalischer Größen in der Nähe oder direkt an einem Substrat, bzw. der auf das Substrat aufgebrachten Schicht ist vor allem bei hochwertigen Schichten wünschenswert. Besonders vorteilhaft kann daher die Beschichtungskammer der Beschichtungsanlage mit einer Funkvorrichtung und einem Messgerät auf ein Hoch- oder Ultrahochvakuum evakuierbar sein. Gleiche oder ähnliche Vorteile wie sie sich für eine Messung in einer Beschichtungskammer ergeben, ergeben sich auch für die Steuerung eines Aktors und/oder einer Heizung.
- Die Substrate können mit einer dünnen Schicht zu beschichten sein, deren Schichtdicke zwischen 3 nm und 100 µm, insbesondere zwischen 50nm und 100µm liegt. Dünne Schichten in dem zuvor angegebenen Schichtdickenbereich sind für die technische Anwendung besonders interessant. Folglich ist es unter kommerziellen Gesichtspunkten besonders vorteilhaft die Beschichtungsanlage dahingehend auszugestalten, dass sie zur Herstellung dünner Schichten in dem erwähnten Schichtdickenbereich geeignet ist.
- Die Substrate können mit einem Material zu beschichten sein, welches mindestens eine Materialkomponente aus einer Gruppe von Materialkomponenten, bestehend aus SiO2, TiO2, HfO, TaO, MgF2, Al2O3, ZrO2, PrTiO3, ZnS enthält. Die vorgenannten Materialien sind vor allem für Beschichtungen, wie sie für optische Anwendungen von Interesse sind, relevant. Eine Messung von physikalischen Größen direkt auf einem Substrathalter ist vor allem für die hochwertigen Schichten, wie sie für optische Anwendungen verwendet werden, besonders interessant. Ebenso ist die Steuerung eines Aktors und/oder einer Heizung für Prozesse in denen die vorgenannten Schichten hergestellt werden besonders interessant.

- Die Substrate können mit einem metallischen Material zu beschichten sein. Metallische Schichten können einen Spezialfall optischer Schichten für einen speziellen Wellenlängenbereich, wie z.B. das XUV oder den Röntgenbereich darstellen, daher treffen die gleichen Vorteile wie im vorstehenden Absatz zu.
- Die Substrate können mit einem Mehrfachschichtsystem aus verschiedenen Materialien zu beschichten sein. Mehrfachschichtsysteme sind komplexe Beschichtungen, die insbesondere für hochwertige optische Anwendungen von Interesse sind. Eine Messung physikalischer Größen, wie auch die Steuerung eines Aktors und/oder einer Heizung direkt auf dem Substrathalter sind daher für solche Mehrfachschichtsysteme besonders interessant.

Weiterhin soll ein erfinderisches Verfahren zur Steuerung eines Aktors angegeben werden. Der Aktor soll in der Beschichtungsanlage angeordnet sein, wobei die Beschichtungsanlage mindestens eine Beschichtungskammer und mindestens einen innerhalb der Beschichtungskammer bewegbar angeordneten Substrathalter zur Aufnahme von zu beschichtenden Substraten, sowie eine Funkvorrichtung mit mindestens einem ersten Funkgerät, welches mit dem Substrathalter verbunden ist, und ein zweites Funkgerät, welches zumindest teilweise außerhalb der Beschichtungskammer angeordnet ist, aufweisen. Das Verfahren zur Steuerung des Aktors soll die folgenden Schritte umfassen. Aufnahme mindestens eines Messwertes mittels eines Messgerätes, welches mit dem Substrathalter verbunden ist; Übertragung des mindestens einen Messwertes über eine zumindest zeitweise zwischen dem ersten und zweiten Funkgerät bestehenden Funkverbindung; Verarbeitung des mindestens einen Messwertes in einer mit dem zweiten Funkgerät verbundenen Datenverarbeitungseinheit zu mindestens einem Steuerbefehl; Übertragung des mindestens einen Steuerbefehls über die zumindest zweitweise zwischen dem zweiten und dem ersten Funkgerät bestehende Funkverbindung an den Aktor. Gemäß dem vorstehenden Verfahren kann der Aktor basierend auf einem direkt auf dem Substrathalter gemessenen Messwert gesteuert werden. Vorteilhaft kann mit diesem Verfahren eine rückgekoppelte Steuerung des Aktors erreicht werden. Beispielsweise kann mit dem Messgerät eine Schichtdicke auf einem sich bewegenden Substrat gemessen werden. Basierend auf dieser Information kann mittels des Aktors eine Drehung dieses Substrates vollzogen werden. Ist die gleiche Schichtdicke auf der Rückseite des Substrates erreicht, was mit dem Messgerät zu messen ist, so kann mittels des Aktors eine Blende geschlossne werden, die den Materialstrom zu dem betreffenden Substrat unterbricht. Auf diese Weise können mit dem vorgenannten Verfahren beispielsweise Substrate mit verschiedenen Schichtdicken in einem Beschichtungsgang und auf ein und demselben Substrathalter hergestellt werden.

Weiterhin soll ein erfinderisches Verfahren zur Steuerung einer Heizung angegeben werden. Die Heizung soll in einer Beschichtungsanlage angeordnet sein, wobei die Beschichtungsanlage mindestens eine Beschichtungskammer und mindestens einen innerhalb der Beschichtungskammer bewegbar angeordneten Substrathalter zur Aufnahme von zu beschichtenden Substraten, sowie eine Funkvorrichtung mit mindestens einem ersten Funkgerät, welches mit dem Substrathalter verbunden ist, und ein zweites Funkgerät, welches zumindest teilweise außerhalb der Beschichtungskammer angeordnet ist, aufweisen. Das Verfahren zur Steuerung der Heizung soll die folgenden Schritte umfassen. Aufnahme mindestens eines Messwertes mittels eines Messgerätes, welches mit dem Substrathalter verbunden ist; Übertragung des mindestens einen Messwertes über eine zumindest zeitweise zwischen dem ersten und zweiten Funkgerät bestehenden Funkverbindung; Verarbeitung des mindestens einen Messwertes in einer mit dem zweiten Funkgerät verbundenen Datenverarbeitungseinheit zu mindestens einem Steuerbefehl; Übertragung des mindestens einen Steuerbefehls über die zumindest zeitweise zwischen dem zweiten und dem ersten Funkgerät bestehende Funkverbindung an die Heizung. Gemäß dem vorstehenden Verfahren kann eine Heizung die mit dem Substrathalter verbunden ist, und ggf. gemeinsam mit diesem in der Beschichtungskammer bewegt wird, basierend auf einem Messwert, der von einem Messgerät, welches ebenfalls mit dem Substrathalter in der Beschichtungskammer bewegt werden kann, gesteuert werden. Auf diese Weise kann beispielsweise die Temperatur eines Substrates gemessen werden. Basierend auf diesem Messwert kann mittels der Heizung die Temperatur des betreffenden Substrates individuell eingestellt und geregelt werden.

Weitere vorteilhafte Ausgestaltungen der erfindungsgemäßen Beschichtungsanlage gehen aus den vorstehend nicht angesprochenen Unteransprüchen sowie insbesondere aus der Zeichnung hervor. Dabei zeigen deren
- Figur 1: eine Beschichtungsanlage mit einer Kalotte als Substrathalter und einer in die Beschichtungsanlage integrierten Funkvorrichtung zur Übertragung von Informationen,
- Figur 2: eine Perspektivansicht eines Substrathalters mit einer Blende zur Abschattung eines Materialstroms,
- Figur 3: eine Perspektivansicht eines Substrathalters, der mittels eines Aktors wendbar ist,
- Figur 4: eine Querschnittsansicht eines Substrathalters, wobei ein Teil des Substrathalters gegenüber einem Bezugsrahmen mit einer gedrehten Feder abgestützt ist,
- Figur 5: eine Draufsicht des Substrathalters aus Figur 4,
- Figur 6: einen Substrathalter mit einer Heizung,
- Figur 7: eine Beschichtungsanlage mit einem drehbaren Substrathalter, wobei mit dem Substrathalter ein Funkgerät, ein Messgerät, ein Aktor und eine Heizung verbunden sind,
- Figur 8: eine Beschichtungsanlage mit einem Substrathalter, der von einem Planetengetriebe angetrieben wird.

Sich in der Zeichnung entsprechende Elemente sind mit den gleichen Bezugszeichen versehen.

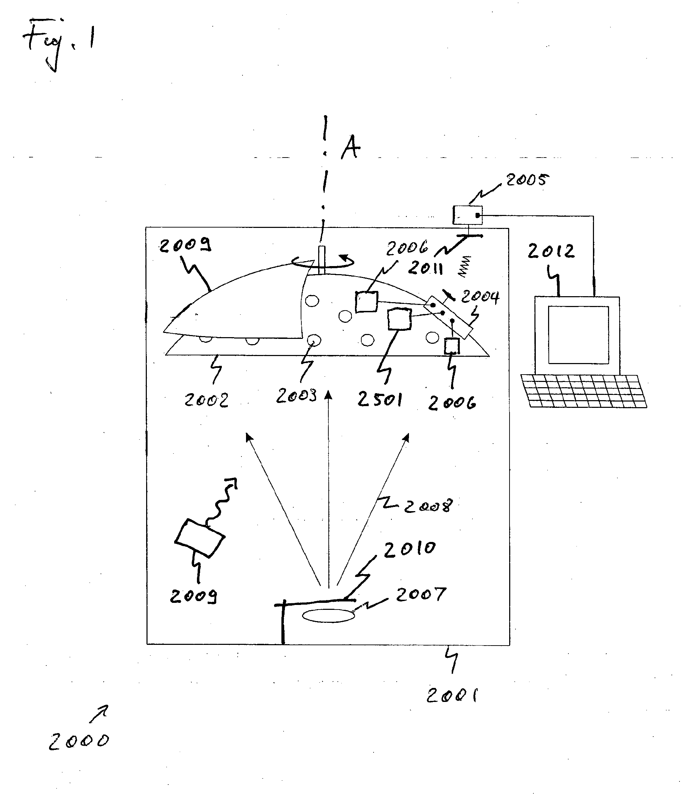

Figur 1 zeigt eine Beschichtungsanlage 2000 gemäß einem bevorzugten Ausführungsbeispiel. Die Beschichtungsanlage 2000 umfasst zumindest eine Beschichtungskammer 2001, in der ein um eine Achse A drehbar angeordneter Substrathalter 2002 angeordnet ist. Die Beschichtungskammer 2001 kann auf einen Druck von typischerweise weniger als 10⁻⁵ mbar evakuierbar sein. Während eines Beschichtungsvorganges herrscht in der Beschichtungskammer 2001 typischerweise ein Druck von etwa 10⁻⁴ mbar. Eine Erhöhung des Druckes in der Beschichtungskammer 2001 von etwa 10⁻⁵ mbar auf etwa 10⁻⁴ mbar ist vorzugsweise durch Einlassen von Sauerstoff in die Beschichtungskammer 2001 realisierbar. Vorzugsweise kann der Substrathalter 2002 in Form einer Kalotte bzw. Drehkalotte ausgestaltet sein. Die Achse A kann in diesem Fall mit der Symmetrieachse der Drehkalotte zusammenfallen.

Der Substrathalter 2002 ist zur Aufnahme von zu beschichtenden Substraten 2003 geeignet. Als Substrate sind beliebige Gläser aber auch metallische oder keramische Werkstoffe geeignet. Vorzugsweise kann als Substratglas CaF2 oder Si02 verwendet werden. Ebenso kann als Substrat eines der folgenden Materialien verwendet werden: MgF2, Al2O3, ZrO2, PrTiO3, TiO2, ZnS.

Die Beschichtung der Substrate 2003 erfolg gemäß dem in Figur 1 dargestellten Ausführungsbeispiel mittels einer Materialquelle 2007. Die Materialquelle 2007 kann sich vorzugsweise im Bodenbereich der Beschichtungskammer 2001 befinden. Bei der Materialquelle 2007 kann es sich um einen Verdampfertiegel, eine Zerstäuberkathode oder eine weitere allgemein bekannte, für Dünnschichtverfahren geeignete Materialquelle handeln. Ausgehend von der Materialquelle 2007 wird, in Figur 1 durch Pfeile angedeutet, aus dieser austretendes Material in Richtung der Unterseite des Substrathalters 2002 deponiert. Folglich werden die Substrate 2003 von dieser Seite her beschichtet. Die Beschichtung der Substrate 2003 kann, wie in Figur 1 dargestellt, mit einer einzelnen Materialquelle 2007 erfolgen. Ebenso können mehrere Materialquellen 2007 zur Beschichtung der Substrate 2003 eingesetzt werden. Bei der Beschichtung der Substrate 2003 mit Hilfe mehrerer Materialquellen 2007 können diese im Bodenbereich der Beschichtungskammer 2001 angeordnet sein. Weiterhin können eine oder mehrere Materialquellen 2007 sowohl im Boden- wie auch im Deckenbereich der Beschichtungskammer 2001 angeordnet sein. Indem mehrere Materialquellen 2007 zur Beschichtung der Substrate 2003 eingesetzt werden, können die Substrate mit mehreren Materialkomponenten gleichzeitig beschichtet werden. Durch die Anordnung einer Materialquelle 2007 im Bodenbereich der Beschichtungskammer 2001 und einer weiteren Materialquelle 2007 im Deckenbereich der Beschichtungskammer 2001 kann eine zweiseitige Beschichtung der Substrate 2003 erreicht werden.

Die Schichtdicken der in der Beschichtungskammer 2001 herzustellenden Schichten können je nach Anforderung an die herzustellenden Schichten variieren. Die Schichtdicken von einzelnen Schichten können sich typischerweise von wenigen Nanometern (ca. 1 bis 3 nm) bis hin zu einigen zehn Mikrometern (ca. 20 bis 100 µm) erstrecken. Weiterhin können mit Hilfe von Mehrfachschichtsystemen optische Spiegel hergestellt werden. Je nach dem ob ein auf diese Weise hergestellter Spiegel im ultravioletten oder im infraroten Spektralbereich reflektieren soll, variiert die Schichtdicke einer einzelnen Schicht des Mehrfachschichtsystems zwischen etwa 10 nm und etwa 1 bis 2 µm. Die in der Beschichtungskammer 2001 herzustellenden Schichten können weiterhin durch einen während und/oder nach der Deposition erfolgenden lonenbeschuss verdichtet bzw. nachverdichtet werden.

Der Substrathalter 2002 kann um die Achse A mit einer typischen Umdrehungsgeschwindigkeit von 40 bis 60 Umdrehungen pro Minute, vorzugsweise mit einer Umdrehungsgeschwindigkeit von 30 bis 50 Umdrehungen pro Minute rotieren. Die Drehung des Substrathalters 2002 ist der gleichmäßigen Beschichtung der Substrate 2003 förderlich. Die Drehgeschwindigkeit kann den jeweiligen Erfordernissen zur Erzielung optimaler Beschichtungsergebnisse auch über die angegebenen Bereiche hinaus angepasst werden.

Zur weiteren gezielten Beeinflussung der Depositionsbedingungen können in der Beschichtungskammer 2001 Heizungen 2009 angeordnet sein. Möglich ist die Installation von einer oder mehreren Heizungen 2009 in beliebiger Position zu dem Substrathalter 2002. Verwendbar sind vorzugsweise Strahlungsheizungen aber auch andere allgemein bekannte Heizungen. Die Heizung 2009 kann im unteren Bereich der Beschichtungskammer 2001 angeordnet sein. Sie kann ebenfalls die Form eines Heizschildes haben, der sich oberhalb des Substrathalters 2002 erstreckt.

Die Materialquelle 2007 kann mit einer Blende 2010 versehen sein, mit der sich der von der Materialquelle 2007 ausgehende Materialstrom 2008 unterbrechen lässt.

Die Beschichtungsanlage 2000 ist weiterhin mit einer Funkvorrichtung versehen, welche aus mindestens zwei Funkgeräten besteht. Ein erstes Funkgerät 2004 ist mit dem Substrathalter 2002 verbunden. Mit diesem ersten Funkgerät 2004 können ein oder mehrere Aktoren 2006 und/oder eine oder mehrere Heizungen 2501 verbunden sein.

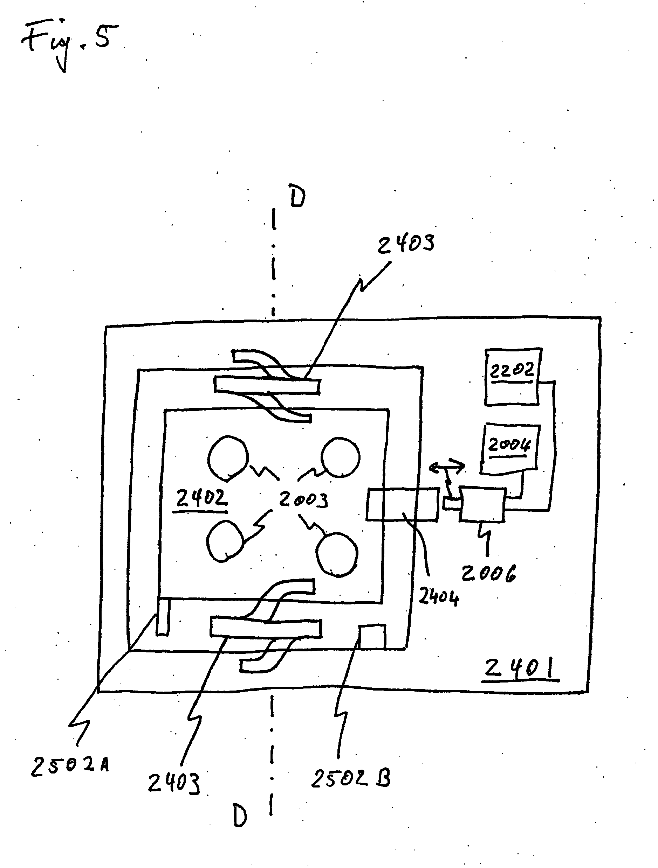

Im Folgenden werden zunächst Ausführungsbeispiele in Bezug auf mit dem ersten Funkgerät 2004 verbundene Aktoren 2006 dargelegt; Ausführungsbeispiele in Bezug auf mit dem ersten Funkgerät 2004 verbundene Heizungen 2501 werden im Zusammenhang mit Figur 5 erläutert.

Neben dem ersten mit dem Substrathalter 2002 verbundenen Funkgerät 2004 ist in die Beschichtungsanlage 2000 ein zweites Funkgerät 2005 intergiert. Das zweite Funkgerät 2005 befindet sich zumindest teilweise außerhalb der Beschichtungskammer 2001. Zur Übertragung von Informationen und Daten über die Funkverbindung kann bzw. können eine oder mehrere Antennen 2011 innerhalb der Beschichtungskammer 2001 angebracht sein, welche mit dem zweiten Funkgerät 2005 verbunden sind. Die Funkverbindung kann monodirektional aufgebaut sein, d.h. eines der beiden Funkgeräte 2004, 2005 ist stets Sender und das entsprechend andere Funkgerät stets Empfänger. Die Funkverbindung kann ebenso bidirektional aufgebaut sein, d.h. beide Funkgeräte 2004, 2005 sind sowohl Sender als auch Empfänger. Weiterhin kann es sich bei der Funkverbindung um eine analoge oder digitale Funkverbindung handeln. Vorzugsweise handelt es sich bei der Funkverbindung um eine digitale Funkverbindung mit einer Frequenz von in etwa 27 MHz, 40MHz, 446MHz, 869 MHz, oder 2,45 GHz. Diese Frequenzen gehören zu den sog. ISM - Frequenzen (Industrial, Scientific and Medical). Es können ebenso können weitere nicht explizit erwähnte ISM - Frequenzen als Trägerfrequenz für die Funkverbindung zwischen dem ersten 2004 und dem zweiten Funkgerät 2005 verwendet werden.

Zur Steuerung des zweiten Funkgerätes 2005 bzw. zur Verarbeitung von Informationen und Daten, die das zweite Funkgerät 2005 empfängt, kann dieses mit einer Datenverarbeitungseinheit 2012 verbunden sein.

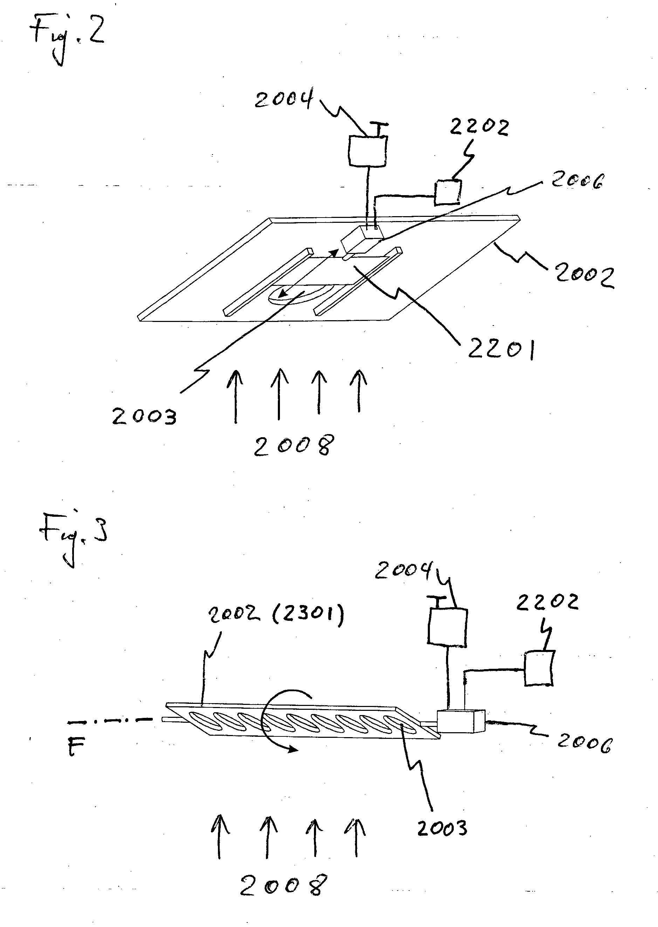

Figur 2 zeigt vorzugsweise einen Teilbereich eines Substrathalters 2002. Es kann sich um einen Substrathalter 2002, der wie in Figur 1 gezeigt, die Form einer Drehkalotte aufweist, handeln. Ebenso kann es sich aber auch um einen Teilbereich eines beliebig andersartig geformten Substrathalters 2002 handeln. Der Substrathalter 2002 soll zur Aufnahme von zu beschichtenden Substraten 2003 geeignet sein. Die Substrate 2003 sind einem Materialstrom 2008 ausgesetzt. Mittels diese Materialstroms 2008 wird eine Schicht auf eine Seite des Substrates 2003 aufgebracht.

Wie bereits im Zusammenhang mit Figur 1 erläutert, kann der von der Materialquelle 2007 ausgehende Materialstrom 2008 mittels einer Blende 2010 unerbrochen werden. Die Blende 2010 befindet sich zentral vor der Materialquelle 2007, d.h. die Materialquelle 2007 kann mittels dieser Blende 2010 global für alle Substrate 2003 unterbrochen werden, die von der betreffenden Materialquelle 2007 beschichtet werden.

Es besteht nun der Wunsch, den Materialstrom 2008 nicht nur global, d.h. im Zweifelsfall für alle in der Beschichtungskammer 2001 befindlichen und von dem Substrathalter 2002 aufgenommenen Substrate 2003 zu unterbrechen, sondern den Materialstrom 2008 individuell für ein einzelnes Substrat 2003 oder eine Gruppe von Substraten 2003 zu unterbrechen. Um diesem Wunsch nachzukommen befindet sich gemäß dem in Figur 2 dargestellten Ausführungsbeispiel eine Blende 2201 in Verbindung mit dem Substrathalter 2002. Mittels dieser Blende 2201 ist es möglich ein einzelnes Substrat 2003, wie in Figur 2 dargestellt, aber auch eine Gruppe von Substraten 2003 von dem Materialstrom 2008 abzuschatten. Die Blende 2201 kann das bzw. die Substrat/e 2003 mittels einer Linear oder Drehbewegung von dem Materialstrom 2008 abschatten. Eine solche Blende 2201 kann insbesondere in Verbindung mit einem sich bewegenden Substrathalter 2002 zum Einsatz gebracht werden. Daher können mit dem Substrathalter 2002 ebenfalls ein Aktor 2006 sowie ein Stromversorgung 2202 für den Aktor 2006 verbunden sein. Bei dem Aktor kann es sich um einen Elektromotor, einen Linearmotor oder weitere allgemein bekannte Aktoren wie z.B. ein Piezoelement oder ein Formgedächtniselement handeln. Der Aktor 2006 ist mit dem ebenfalls mit dem Substrathalter 2002 verbundenen ersten Funkgerät 2004 verbunden. Mit Hilfe der vorbeschriebenen Einrichtung kann während eines laufenden Beschichtungsprozesses ein oder mehrere Substrat/e 2003 von dem Materialstrom 2008 abgeschattet werden. Die mit dem Substrathalter 2002 vorzugsweise in der Beschichtungskammer 2001 bewegte Blende 2201 kann dabei von einem Ort außerhalb der Beschichtungskammer 2001, z.B. von einer Datenverarbeitungseinheit 2012 gesteuert werden. Auf diese Weise ist es möglich in einem Beschichtungsprozess verschiedene Produkte herzustellen. So können z.B. Gläser mit unterschiedlich dicken Beschichtungen versehen werden. Kostspielige Wartezeiten z.B. zum Abpumpen der Beschichtungskammer 2001 oder zum Einjustieren der Materialquelle 2007 können bei dem vorstehenden Ausführungsbeispiel entfallen.

Figur 3 zeigt einen Substrathalter 2002, bzw. ein Teil eines Substrathalters 2301 der mittels eines Aktors 2006 um eine Achse F drehbar ist. Ein Substrathalter 2002, vorzugsweise ein kalottenförmiger Substrathalter 2002 wie er in Figur 1 gezeigt ist, kann mehrere Elemente/Teile 2301 wie eines in Figur 3 gezeigt ist, enthalten. Im Folgenden sei das Element 2301 allgemein als Substrathalter bezeichnet. Der Substrathalter 2301 ist zur Aufnahme von zu beschichtenden Substraten 2003 geeignet. Vorzugsweise bewegt sich der Substrathalter 2301 in einem Materialstrom 2008. Die von dem Substrathalter 2301 aufgenommenen Substrate 2003 werden auf ihrer dem Materialstrom 2008 zugewandten Seite beschichtet. Nachdem die gewünschte Schichtdicke auf die Substrate 2003 aufgebracht worden ist, kann der Substrathalter 2301 und mit ihm die entsprechenden Substrate 2003 um die Achse F gedreht werden. Die Drehung kann vorzugsweise 180° betragen, so dass nach der Drehung die entgegengesetzte Seite der Substrate 2003 von dem Materialstrom 2008 getroffen und somit beschichtet wird. Zur Drehung des Substrathalters 2301 ist mit diesem ein Aktor 2006 verbunden. Vorzugsweise kann es sich bei dem Aktor 2006 um einen Elektromotor handeln. Der Aktor 2006 ist zum einen mit einer Stromversorgung 2202, und zum anderen mit dem ersten Funkgerät 2004 verbunden. Zur Steuerung des Aktors 2006 können von einem Ort außerhalb der Beschichtungskammer 2001, z.B. von einer Datenverarbeitungseinheit 2012 über die zwischen dem zweiten 2005 und dem ersten Funkgerät 2004 zumindest teilweise bestehende Funkverbindung Steuerbefehle an den Aktor 2006 gesendet werden. Mit einer Beschichtungsanlage 2000 gemäß dem vorstehenden Ausführungsbeispiel ist es möglich einzelne Substrate 2003 oder, wie in Figur 3 gezeigt, eine Gruppe von Substraten 2003 bei laufendem Beschichtungsprozess zu drehen, und auf diese Weise für eine zweiseitige Beschichtung der Substrate 2003 zu sorgen. Die Substrate 2003 können ebenfalls fortlaufend gedreht werden z.B. um eine besonders gute Homogenität der auf der Vorder- und der Rückseite der Substrate 2003 aufgebrachten Schicht oder Schichten zu erreichen.

Ein Substrathalter 2301, wie er in Figur 3 gezeigt ist, kann ebenfalls ein Segment 2301 eines größeren Substrathalters 2002 sein. Beispielsweise kann ein annähernd kalottenförmiger Substrathalter 2002 aus Segmenten 2301 bestehen, deren Drehachsen F radial bzw. sternförmig in Bezug auf die Kalotte orientiert sind. In diesem Fall können die einzelnen Segmente 2301 eines näherungsweise kalottenförmigen Substrathalters 2002 unabhängig voneinander gedreht werden.

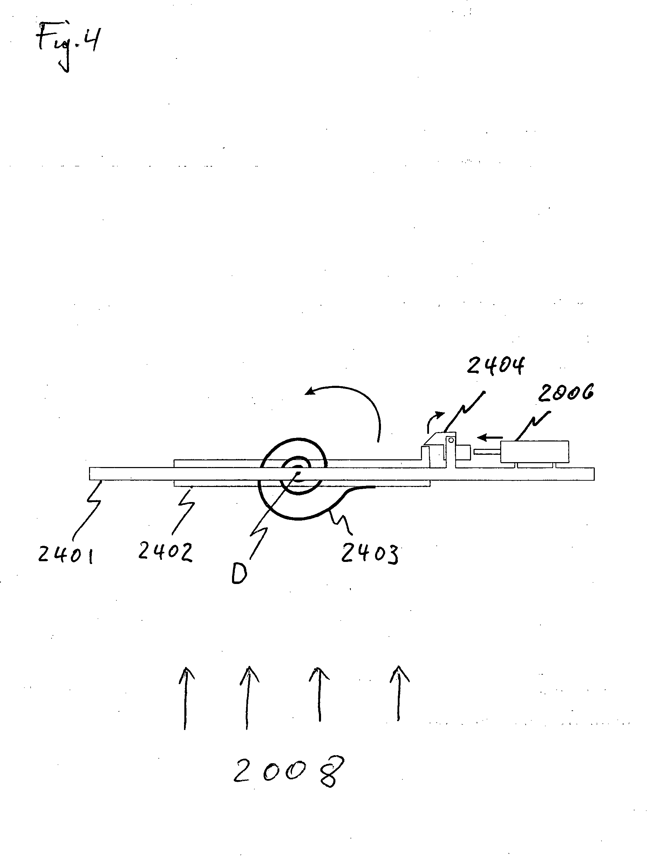

Figur 4 zeigt einen Teil eines Substrathalters 2002 gemäß einem weiteren Ausführungsbeispiel. Die in Figur 4 gezeigte Anordnung kann ein Teil eines kalottenförmigen Substrathalters 2002 sein, sie kann aber auch ein Teil eines beliebig andersartig geformten Substrathalters 2002 sein. Die in Figur 4 gezeigte Anordnung besteht zumindest aus einem Bezugsrahmen 2401 und einem beweglichen Substrathalter 2402, der mittels mindestens einer gedrehten Feder 2403 gegenüber dem Bezugsrahmen 2401 abgestützt ist. Der Bezugsrahmen 2401 kann beispielsweise ein Teil eines kalottenförmigen Substrathalters 2002, wie er in Figur 1 gezeigt und mit 2002 bezeichnet ist, sein. Bei der gedrehten Feder 2403 kann es sich um eine allgemein bekannte gedrehte Blattfeder oder um eine andere allgemein bekannte für das vorliegende Ausführungsbeispiel geeignete Feder 2403 handeln. Der Substrathalter 2402 ist gegenüber dem Bezugsrahmen 2401 im Wesentlichen um eine Achse D drehbar gelagert. Die Lagerung des Substrathalters 2402 gegenüber dem Bezugsrahmen 2401 ist mittels zweier gedrehter Federn 2403 unter Verzicht auf eine mechanische Achse realisiert, d.h. der Substrathalter 2402 ist lediglich mittels der gedrehten Federn 2403 gegenüber dem Bezugsrahmen 2401 abgestützt. Dies wird insbesondere in der Zusammenschau von Figur 4 mit Figur 5 deutlich. Eine achslose Halterung des Substrathalters 2402 gegenüber dem Bezugsrahmen 2401 ist besonders für Beschichtungsanlagen vorteilhaft. Achslager neigen dazu, insbesondere wenn der Bereich des Achslagers dem Materialstrom 2008 ausgesetzt ist, zu blockieren oder Störungen aufzuweisen. Das in den Bereich des Lagerspaltes oder direkt in den Lagerspalt deponierte Material kann die freie Drehbarkeit der Achse verringern.

Der Substrathalter 2402 ist zur Aufnahme von einem oder mehreren zu beschichtenden Substraten 2003 geeignet. Die Substrate 2003 werden zu ihrer Beschichtung einem Materialstrom 2008 ausgesetzt. Da die Substrate 2003 in diesem Fall typischerweise lediglich von einer Seite beschichtet werden, ist es wünschenswert die Substrate 2003 bzw. den die Substrate 2003 aufnehmenden Substrathalter 2402 um vorzugsweise 180° gegenüber dem Materialstrom 2008 zu drehen. Dies kann auf besonders einfache und effektive Weise, gemäß einer Ausführungsform, mit dem zuvor beschriebenen Substrathalter 2402 geschehen.

Der Substrathalter 2402 kann gegenüber dem Bezugsrahmen 2401 bedingt durch die Federkraft der gedrehten Feder 2403 unter Vorspannung stehen. Der Substrathalter 2402 wird von einer Arretierung 2404 gegenüber dem Bezugsrahmen 2401 in einer Ruhelage gehalten. Die Arretierung 2404 kann von dem Aktor 2006 gelöst werden, so dass der Substrathalter 2402 für eine näherungsweise 180° - Drehung gegenüber dem Bezugsrahmen 2401 freigegeben wird. Zu diesem Zweck kann der in Figur 4 angedeutete mechanische Aufbau von Arretierung 2404 und Aktor 2006 verwendet werden. Ebenso kann ein weiterer allgemein bekannter mechanischer Aufbau, der den selben Zweck, nämlich eine Arretierung des unter Vorspannung stehenden Substrathalters 2402, erfüllt, beispielsweise eine Verriegelung in Form eines Riegels, verwendet werden.

Durch die Vorspannung der gedrehten Feder 2403 getrieben, vollzieht der Substrathalter 2402 eine näherungsweise 180° - Drehung und wird am Ende dieser Drehung von zwei als Anschlag wirkenden Elementen arretiert. Hierbei tritt ein mit dem Substrathalter 2402 verbundenes Anschlagelement 2502A in Kontakt mit einem mit dem Bezugsrahmen 2401 verbundenen Anschlagelement 2502B.

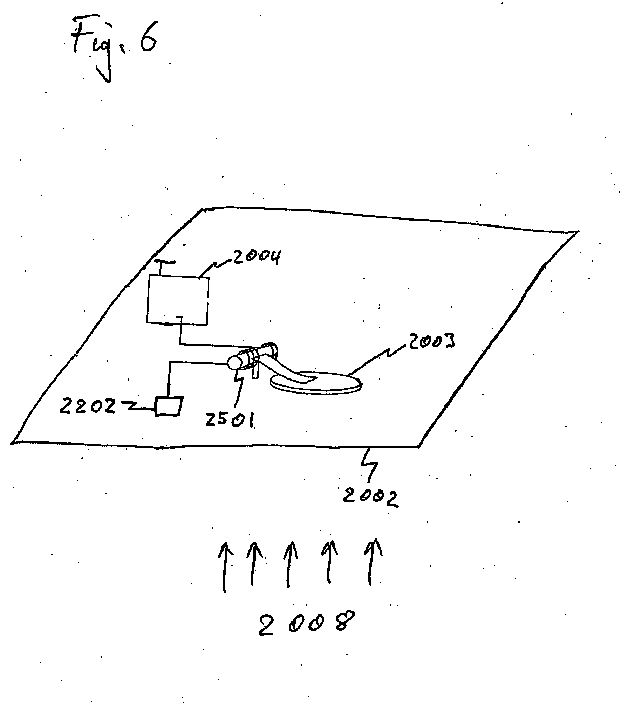

Figur 6 zeigt einen Teil eines Substrathalters 2002 mit einer Heizung 2501, gemäß einem weiteren Ausführungsbeispiel. Der in Figur 6 dargestellte Teil eines Substrathalters 2002 kann wiederum ein Teil eines kalottenförmigen Substrathalters 2002 sein, ebenso ist aber auch jeder andersartig geformte Substrathalter 2002 verwendbar. Das von dem Substrathalter 2002 aufgenommene Substrat 2003 ist vorzugsweise auf seiner dem Materialstrom 2008 abgewandten Seite mit einer Heizung 2501 thermisch verbunden. Typischerweise kann es sich bei der Heizung 2501 um eine Widerstandsheizung handeln, die direkt oder indirekt mit dem Substrat 2003 in Verbindung gebracht wird. Die Heizung 2501 ist zum einen mit einer Stromversorgung 2202 und zum anderen mit dem ersten Funkgerät 2004 verbunden. Auf diese Weise kann die Heizung 2501 von einem Ort außerhalb der Beschichtungskammer 2001 gesteuert werden. In einer Beschichtungsanlage 2000 gemäß dem vorstehenden Ausführungsbeispiel kann die Temperatur einzelner Substrate 2003 oder einer Gruppe von Substraten 2003 individuell, beispielsweise von einer Datenverarbeitungseinheit 2012 außerhalb der Beschichtungskammer 2001 gesteuert werden.

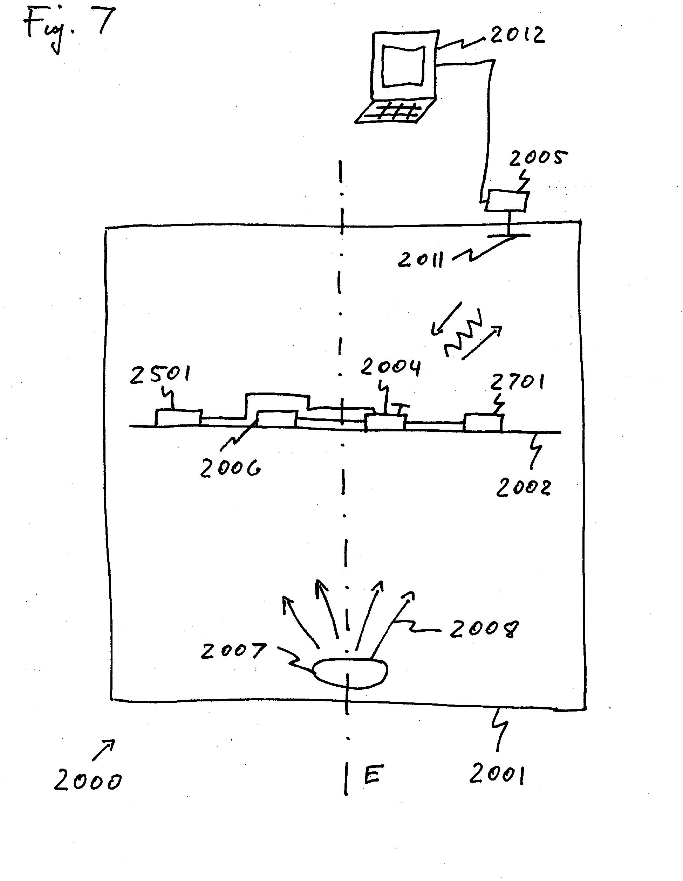

Figur 7 zeigt eine Beschichtungsanlage 2000 gemäß einem weiteren Ausführungsbeispiel. Die Beschichtungsanlage 2000 weist zumindest eine Beschichtungskammer 2001 und einen innerhalb der Beschichtungskammer 2001 drehbar angeordneten Substrathalter 2002 auf. Der Substrathalter 2002 ist um eine Achse E drehbar gelagert und kann vorzugsweise in Form einer Kalotte ausgestaltet sein.

Mit dem Substrathalter 2002 kann ein erstes Funkgerät 2004 sowie ein Aktor 2006, eine Heizung 2501 sowie ein Messgerät 2701 verbunden sein. Gemäß weiteren Ausführungsbeispielen, auf die hier nicht näher eingegangen werden soll kann mit dem Substrathalter 2002 ein Messgerät 2701 und ein Aktor 2006 oder ein Messgerät 2701 und eine Heizung 2501 verbunden sein.

Der Aktor 2006 kann gemäß einer in den Figuren 2 bis 5 dargestellten Ausführungsform ausgestaltet sein, die Heizung 2501 kann gemäß der in Figur 6 dargestellten Ausführungsform ausgestaltet sein. Das Messgerät 2701 kann insbesondere mit Messonden zur Messung verschiedener physikalischer Größen verbunden sein. Mit einer dieser Messsonden kann insbesondere die Temperatur eines oder mehrerer Substrate 2003 gemessen werden kann. Vorzugsweise kann als eine solche Temperaturmesssonde ein Thermoelement z.B. ein Ni/NiCr - Thermoelement verwendet werden. Gemäß weiteren Ausführungsbeispielen können mit Hilfe der Messgerätes 2701 weitere physikalische Größen innerhalb der Beschichtungskammer 2001 gemessen werden. Zu diesem Zweck können weitere Messsonden mit dem Messgerät 2701 verbunden sein. Diese weiteren Messsonden können zur Messung von Gasdrücken, Stromstärken, Spannungen, Widerständen, Kräften und/oder weiteren physikalischen Größen geeignet sein. Die Messsonden können direkt in Kontakt mit den Substraten 2003, oder der auf die Substrate 2003 deponierten Schicht gebracht werden. Ebenso können die Messsonden in die Nähe der Substrate 2003 gebracht werden und/oder in thermischem oder mechanischem Kontakt mit dem Substrathalter 2002 stehen. Eine komplexe Messsonde kann ein Schwingquarz zur Bestimmung einer Schichtdicke sein. Die Frequenz des Schwingquarzes kann mit Hilfe des Messgerätes 2701 ausgelesen werden. Auf diese Weise kann die deponierte Masse bzw. die deponierte Schichtdicke direkt an einem definierten Ort auf dem Substrathalter 2002 gemessen werden. Eine weitere Möglichkeit für die Ausgestaltung einer Messsonde ist eine Einrichtung, mit der die auf einem Substrat 2003 deponierte Schichtdicke gemessen werden kann. Dies kann beispielsweise mit Hilfe einer interferrometrischen Messung erfolgen. In diesem Fall besteht die Messonde zumindest aus einer Lichtquelle z.B. einer LED oder Laserdiode und einem Photodetektor. Die Messung der Schichtdicke auf einem Substrat 2003 erfolgt, wie allgemein aus dem Stand der Technik bekannt, anhand der Analyse der Intensitätsmaxima und Minima des an der entsprechenden Schicht reflektierten Lichtanteils der Lichtquelle.

Ein oder mehrere Messwerte, die von dem Messgerät 2701 innerhalb der Beschichtungskammer 2001 aufgenommen werden, können über die zwischen dem ersten Funkgerät 2004 und dem zweiten, zumindest teilweise außerhalb der Beschichtungskammer 2001 angeordneten, Funkgerät 2005 bestehenden Funkverbindung übertragen werden. Mit dem zweiten Funkgerät 2005 kann eine Datenverarbeitungseinheit 2012 verbunden sein. Mit Hilfe der Datenverarbeitungseinheit 2012 können die empfangenen Messwerte zu Steuerbefehlen für die Heizung 2501 und/oder den Aktor 2006 verarbeitet werden. Diese Steuerbefehle können über das zweite 2005 und das erste Funkgerät 2004 an den Aktor 2006 und/oder die Heizung gesendet werden.

Mit einer Beschichtungsanlage 2000 gemäß dem vorstehenden Ausführungsbeispiel kann eine rückgekoppelte Steuerung des Aktors 2006 und/oder der Heizung 2501 erfolgen. So kann beispielsweise mit Hilfe des Messgerätes 2701 eine Substrattemperatur bestimmt werden. Dieser Messwert kann von der Datenverarbeitungseinheit 2012 mit einem bestimmten Sollwert verglichen werden, aus diesem Vergleich können Steuerbefehle für die Heizung 2501 berechnet werden, so dass die Substrattemperatur individuell für ein einzelnes oder eine Gruppe von Substraten 2003 gemessen und gesteuert werden kann. Weiterhin kann beispielsweise mit Hilfe des Messgerätes 2701 eine Schichtdicke an einem oder mehreren Substraten 2003 gemessen werden. Basierend auf diesem Messwert kann mittels der Datenverarbeitungseinheit 2012 ein Steuerbefehl für den Aktor 2006 errechnet werden. So kann der Aktor 2006 z.B. dafür sorgen, dass eine Drehung eines oder mehrerer Substrate 2003 durchgeführt wird oder, dass eine Blende 2201 zur Abschattung der betreffenden Substrate 2003 in den Materialstrom 2008 gefahren wird.

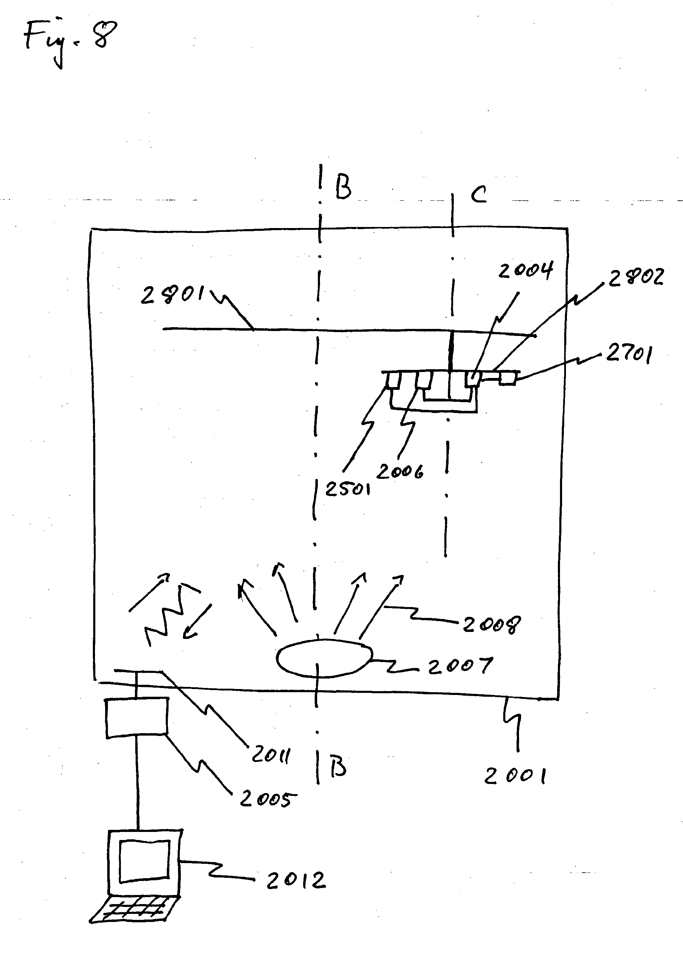

Figur 8 zeigt eine Beschichtungsanlage 2000 gemäß einem weiteren Ausführungsbeispiel. Gegenüber den aus den vorhergehenden Figuren bekannten Ausführungsbeispielen ist in der Beschichtungskammer 2001 ein Planetengetriebe 2801 angeordnet. Dieses Planetengetriebe 2801 ist um eine Achse B drehbar gelagert. Mit Hilfe des Planetengetriebes 2801 kann ein Substrathalter 2802 in eine Drehung um eine Achse C versetzt werden. Das Planetengetriebe 2801 kann zum Antrieb eines oder mehrerer Substrathalter 2802 geeignet sein. Die Achsen B und C können weiterhin vorzugsweise parallel verlaufen. Weiterhin können die Achsen B und C in einem fest einstellbaren Winkel zueinander stehen. In gleicher oder sehr ähnlicher Weise, wie im Zusammenhang mit den vorausgehenden Figuren gezeigt kann auch bei dem in Figur 8 gezeigten Ausführungsbeispiel ein erstes Funkgerät 2004, ein Aktor 2006, eine Heizung 2501 und/oder ein Messegerät 2701 mit dem Substrathalter 2801 verbunden sein. Ebenso wie im Zusammenhang mit Figur 7 beschrieben kann auch gemäß dem in Figur 8 gezeigten Ausführungsbeispiel eine Regelung des Aktors 2006 und/oder der Heizung 2501 basierend auf einem oder mehreren Messwerten des Messgerätes 2701 erfolgen.

## Patentansprüche

1. Beschichtungsanlage (2000) mit einer Beschichtungskammer (2001) und mindestens einem innerhalb der Beschichtungskammer (2001) bewegbar angeordneten Substrathalter (2002) zur Aufnahme von zu beschichtenden Substraten (2003), und
- einer Funkvorrichtung mit mindestens
-- einem ersten Funkgerät (2004), welches mit dem Substrathalter (2002) verbunden ist, und
-- einem zweiten Funkgerät (2005), welches zumindest teilweise außerhalb der Beschichtungskammer (2001) angeordnet ist,
wobei
zwischen dem ersten (2004) und dem zweiten Funkgerät (2005) zumindest zeitweise eine Funkverbindung zur Übertragung von Informationen besteht, und wobei
mit dem ersten Funkgerät (2004) mindestens ein Aktor (2006) verbunden ist, welcher in Wirkverbindung mit dem ersten Funkgerät (2004) steht und mit dem Substrathalter (2002) verbunden ist.

2. Beschichtungsanlage (2000) gemäß Anspruch 1, **dadurch gekennzeichnet, dass** die Informationen Steuerbefehle für den Aktor (2006) enthalten.

3. Beschichtungsanlage (2000) gemäß Anspruch 2, **dadurch gekennzeichnet, dass** der Aktor (2006) mindestens eine mit dem Substrathalter (2002) verbundene Blende (2201) zur Unterbrechung eines Materialstroms (2008) steuert, der von einer innerhalb der Beschichtungskammer (2001) angeordneten Materialquelle (2007) ausgeht.

4. Beschichtungsanlage (2000) gemäß Anspruch 2, **dadurch gekennzeichnet, dass** der Aktor (2006) eine Drehung mindestens eines Substrates (2003) bewirkt.

5. Beschichtungsanlage (2000) gemäß Anspruch 4, **dadurch gekennzeichnet, dass** zumindest Teile des Substrathalters (2002) um eine Achse (D) drehbar sind und achsfrei mittels mindestens einer im wesentlichen koaxial zu der Achse (D) gedrehten Feder (2403) gegenüber einem Bezugsrahmen (2401) abgestützt sind.

6. Beschichtungsanlage (2000) gemäß Anspruch 1, **dadurch gekennzeichnet, dass** mit dem ersten Funkgerät (2004) mindestens eine Heizung (2501) verbunden ist, die in Wirkverbindung mit dem ersten Funkgerät (2004) steht und mit dem Substrathalter (2002) verbunden ist.

7. Beschichtungsanlage (2000) gemäß mindestens einem der Ansprüche 1 oder 6, **dadurch gekennzeichnet, dass** das erste Funkgerät (2004) mit einem Messgerät (2701) verbunden ist, welches in Wirkverbindung mit dem ersten Funkgerät (2004) steht und mit dem Substrathalter (2002) verbunden ist.

8. Beschichtungsanlage (2000) gemäß Anspruch 7, **dadurch gekennzeichnet, dass** das Messgerät (2701) zur Messung mindestens einer physikalischen Größe aus einer Gruppe von physikalischen Größen, bestehend aus einer Substrattemperatur, einem Gasdruck, einer elektrischen Spannung, einem elektrischen Widerstand, oder einer Schichtdicke, einer auf einem zu beschichtenden Substrat (2003) abgeschiedenen Schicht, geeignet ist.

9. Beschichtungsanlage (2000) gemäß einem der Ansprüche 1 bis 8, **dadurch gekennzeichnet, dass** in der Beschichtungskammer (2001) ein um eine Hauptachse (B) drehbares Planetengetriebe (2801) angeordnet ist, welches dazu geeignet ist mindestens den mit dem Planetengetriebe (2801) verbundenen Substrathalter (2002) in eine Drehung um eine um eine Achse (C) zu versetzen, welche im wesentlichen parallel zu der Hauptachse (B) orientiert ist.

10. Beschichtungsanlage (2000) gemäß einem der vorstehenden Ansprüche, **dadurch gekennzeichnet, dass** die Trägerfrequenz der Funkverbindung eine ISM-Frequenz ist.

11. Beschichtungsanlage (2000) gemäß einem der vorstehenden Ansprüche, **dadurch gekennzeichnet, dass** die Beschichtungskammer (2001) eine Vakuumkammer, vorzugsweise eine Hochvakuum- oder Ultrahochvakuumkammer ist.

12. Verfahren zur Steuerung eines Aktors (2006) in einer Beschichtungsanlage (2000), wobei die Beschichtungsanlage (2000) mindestens eine Beschichtungskammer (2001) und mindestens einen innerhalb der Beschichtungskammer (2001) bewegbar angeordneten Substrathalter (2002) zur Aufnahme von zu beschichtenden Substraten (2003), sowie
- eine Funkvorrichtung mit mindestens
-- einem ersten Funkgerät (2004), welches mit dem Substrathalter (2002) verbunden ist, und
-- einem zweiten Funkgerät (2005), welches zumindest teilweise außerhalb der Beschichtungskammer (2001) angeordnet ist aufweist,
die folgenden Schritte umfassend:
- Aufnahme mindestens eines Messwertes mittels eines Messgerätes (2701), welches mit dem Substrathalter (2002) verbunden ist,
- Übertragung des mindestens einen Messwertes über eine zumindest zeitweise zwischen dem ersten (2004) und zweiten Funkgerät (2005) bestehende Funkverbindung,
- Verarbeitung des mindestens einen Messwertes in einer mit dem zweiten Funkgerät (2005) verbundenen Datenverarbeitungseinheit (2012) zu mindestens einem Steuerbefehl,
- Übertragung des mindestens einen Steuerbefehles über die zumindest zeitweise zwischen dem zweiten (2005) und dem ersten Funkgerät (2004) bestehende Funkverbindung an den Aktor (2006).

13. Verfahren zur Steuerung einer Heizung (2501) in einer Beschichtungsanlage (2000), wobei die Beschichtungsanlage (2000) mindestens eine Beschichtungskammer (2001) und mindestens einen innerhalb der Beschichtungskammer (2001) bewegbar angeordneten Substrathalter (2002) zur Aufnahme von zu beschichtenden Substraten (2003), sowie
- eine Funkvorrichtung mit mindestens
-- einem ersten Funkgerät (2004), welches mit dem Substrathalter (2002) verbunden ist, und
-- einem zweiten Funkgerät (2005), welches zumindest teilweise außerhalb der Beschichtungskammer (2001) angeordnet ist aufweist,
die folgenden Schritte umfassend:
- Aufnahme mindestens eines Messwertes mittels eines Messgerätes (2701), welches mit dem Substrathalter (2002) verbunden ist,
- Übertragung des mindestens einen Messwertes über eine zumindest zeitweise zwischen dem ersten (2004) und zweiten Funkgerät (2005) bestehende Funkverbindung,
- Verarbeitung des mindestens einen Messwertes in einer mit dem zweiten Funkgerät (2005) verbundenen Datenverarbeitungseinheit (2012) zu mindestens einem Steuerbefehl,
- Übertragung des mindestens einen Steuerbefehles über die zumindest zeitweise zwischen dem zweiten (2005) und dem ersten Funkgerät (2004) bestehende Funkverbindung an die Heizung (2501).

## Claims

1. A deposition apparatus (2000) comprising a deposition chamber (2001) and at least one substrate holder (2002) movably arranged within the deposition chamber (2001) for holding substrates (2003) to be coated, and
- radio equipment having at least
-- a first radio device (2004) which is connected to the substrate holder (2002), and
-- a second radio device (2005) which is arranged at least partially outside the deposition chamber (2001),
wherein
a radio link for transferring information being established at least temporarily between the first radio device (2004) and the second radio device (2005), and wherein
at least one actuator (2006) being connected to the first radio device (2004) which is in operative connection with the first radio device (2004) and is connected to the substrate holder (2002).

2. The deposition apparatus (2000) according to claim 1, **characterized in that** the information include control commands for the actuator (2006).

3. The deposition apparatus (2000) according to claim 1, **characterized in that** the actuator (2006) controls at least one shield (2201) connected to the substrate holder (2002) for interrupting a material flow (2008) coming from a material source (2007) arranged within the deposition chamber (2001).

4. The deposition apparatus (2000) according to claim 3, **characterized in that** the actuator (2006) effects turning of at least one substrate (2003).

5. The deposition apparatus (2000) according to claim 4, **characterized in that** at least parts of the substrate holder (2002) can be turned about an axis (D) and are supported relative to the reference frame (2401) without the use of an axle by means of at least one spring (2403) twisted substantially coaxially to the axis (D).

6. The deposition apparatus (2000) according to claim 1, **characterized in that** to the first radio device (2004) at least one heating system (2501) is connected which is in operative connection with the first radio device (2004) and is connected to the substrate holder (2002).

7. The deposition apparatus (2000) according to at least one of the claims 1 or 6, **characterized in that** the first radio device (2004) is connected to a measuring device (2701) which is in operative connection with the first radio device (2004) and is connected to the substrate holder (2002).

8. The deposition apparatus (2000) according to claim 7, **characterized in that** the measuring device (2701) is suitable for measuring at least one physical quantity from a group of physical quantities comprising a substrate temperature, a gas pressure, an electrical voltage, an electrical resistance, or a layer thickness of a layer deposited on a substrate (2003) to be coated.

9. The deposition apparatus (2000) according to one of the claims 1 to 8, **characterized in that** in the deposition chamber (2001) a planetary gear (2801) rotatable about a main axis (B) is arranged, which planetary gear is suitable for rotating at least the substrate holder (2002) connected to the planetary gear (2701) about an axis (C) which is oriented substantially parallel to the main axis (B).

10. The deposition apparatus (2000) according to one of the preceding claims, **characterized in that** the carrier frequency of the radio link is an ISM frequency.

11. The deposition apparatus (2000) according to one of the preceding claims, **characterized in that** the depositing chamber (2001) is a vacuum chamber, preferably a high vacuum or ultrahigh vacuum chamber.

12. A method for controlling an actuator (2006) in a deposition apparatus (2000), the deposition apparatus (2000) comprising at least one deposition chamber (2001) and at least one substrate holder (2002) movably arranged within the deposition chamber (2001) for holding substrates (2003) to be coated, and
- radio equipment having at least
-- a first radio device (2004) which is connected to the substrate holder (2002), and
-- a second radio device (2005) which is arranged at least partially outside the deposition chamber (2001),
comprising the following steps:
- recording at least one measured value by means of a measuring device (2701) which is connected to the substrate holder (2002),
- transferring the at least one measured value via a radio link established at least temporarily between the first radio device (2004) and the second radio device (2005),
- processing the at least one measured value in a data processing unit (2012) connected to the second radio device (2005) into at least one control command,
- transferring the at least one control command via the radio link established at least temporarily between the second radio device (2005) and the first radio device (2004) to the actuator (2006).

13. A method for controlling a heating system (2501) in a deposition apparatus (2000), the deposition apparatus (2000) comprising at least one deposition chamber (2001) and at least one substrate holder (2002) movably arranged within the deposition chamber (2001) for holding substrates (2003) to be coated, and
- radio equipment having at least
-- a first radio device (2004) which is connected to the substrate holder (2002), and
-- a second radio device (2005) which is arranged at least partially outside the deposition chamber (2001),
comprising the following steps:
- recording at least one measured value by means of a measuring device (2701) which is connected to the substrate holder (2002),
- transferring the at least one measured value via a radio link established at least temporarily between the first radio device (2004) and the second radio device (2005),
- processing the at least one measured value in a data processing unit (2012) connected to the second radio device (2005) into at least one control command,
- transferring the at least one control command via the radio link established at least temporarily between the second radio device (2005) and the first radio device (2004) to the heating system (2006).

## Revendications

1. Installation d'application de revêtement (2000) comprenant une chambre d'application de revêtement (2001) et au moins un porte-substrat (2002) conçu pour recevoir des substrats (2003) à revêtir et qui est monté mobile à l'intérieur de la chambre d'application de revêtement (2001), et comprenant
- un dispositif radio comportant au moins
-- un premier appareil radio (2004), lequel est relié au porte-substrat (2002), et
-- un second appareil radio (2005), lequel est disposé au moins en partie à l'extérieur de la chambre d'application de revêtement (2001),
une liaison radio étant établie au moins temporairement entre le premier (2004) et le second appareil radio (2005) pour transmettre des informations, et
au moins un actionneur (2006) relié au premier appareil radio (2004), coopérant avec le premier appareil radio (2004) et étant relié au porte-substrat (2002).

2. Installation d'application de revêtement (2000) selon la revendication 1, **caractérisée en ce que** les informations comportent des instructions de commande pour l'actionneur (2006).

3. Installation d'application de revêtement (2000) selon la revendication 2, **caractérisée en ce que** l'actionneur (2006) commande au moins un obturateur (2201) relié au porte-substrat (2002) pour interrompre un courant de matière (2008) qui sort d'une source de matière (2007) disposée à l'intérieur de la chambre d'application de revêtement (2001).

4. Installation d'application de revêtement (2000) selon la revendication 2, **caractérisée en ce que** l'actionneur (2006) provoque une rotation d'au moins un substrat (2003).

5. Installation d'application de revêtement (2000) selon la revendication 4, **caractérisée en ce qu'**au moins des parties du porte-substrat (2002) peuvent tourner autour d'un axe (D) et sont en appui sans axe relativement à un cadre de référence au moyen d'au moins un ressort (2403) amené en rotation sensiblement coaxialement à l'axe (D).

6. Installation d'application de revêtement (2000) selon la revendication 1, **caractérisée en ce qu'**au moins un dispositif de chauffage (2501), qui coopère avec le premier appareil radio (2004) et est relié au porte-substrat (2002), est relié au premier appareil radio (2004).

7. Installation d'application de revêtement (2000) selon l'une quelconque des revendications 1 à 6, **caractérisée en ce que** le premier appareil radio (2004) est relié à un appareil de mesure (2701), lequel coopère avec le premier appareil radio (2004) et est relié au porte-substrat (2002).

8. Installation d'application de revêtement (2000) selon la revendication 7, **caractérisée en ce que** l'appareil de mesure (2701) est destiné à mesurer au moins une grandeur physique choisie dans un groupe de grandeurs physiques, constitué d'une température du substrat, d'une pression du gaz, d'une tension électrique, d'une résistance électrique ou d'une épaisseur de la couche, d'une couche déposée sur un substrat (2003) à revêtir.

9. Installation d'application de revêtement (2000) selon l'une quelconque des revendications 1 à 8, **caractérisée en ce qu'**un engrenage planétaire (2801) pouvant tourner autour d'un axe principal (B) est disposé dans la chambre d'application de revêtement (2001), ledit engrenage planétaire étant conçu pour mettre en rotation au moins le porte-substrat (2002) relié à l'engrenage planétaire (2801) autour d'un axe (C), lequel est orienté sensiblement parallèlement à l'axe principal (B).

10. Installation d'application de revêtement (2000) selon l'une quelconque des revendications précédentes, **caractérisée en ce que** la fréquence porteuse de la liaison radio est une fréquence ISM.

11. Installation d'application de revêtement (2000) selon l'une quelconque des revendications précédentes, **caractérisée en ce que** la chambre de revêtement (2001) est une chambre à vide, de préférence une chambre à vide poussé ou ultra-poussé.

12. Procédé de commande d'un actionneur (2006) dans une installation d'application de revêtement (2000), l'installation d'application de revêtement (2000) comprenant au moins une chambre d'application de revêtement (2001) et au moins un porte-substrat (2002) qui est conçu pour recevoir des substrats (2003) à revêtir et qui est monté mobile à l'intérieur de la chambre d'application de revêtement (2001), et comprenant
- un dispositif radio comportant au moins
-- un premier appareil radio (2004), lequel est relié au porte-substrat (2002), et
-- un second appareil radio (2005), lequel est disposé au moins en partie à l'extérieur de la chambre d'application de revêtement (2001),
ledit procédé comportant les étapes suivantes :
- l'enregistrement d'au moins une valeur de mesure au moyen d'un appareil de mesure (2701), lequel est relié au porte-substrat (2002),
- la transmission de la ou des valeurs de mesure par l'intermédiaire d'une liaison radio présente au moins temporairement entre le premier (2004) et le second appareil radio (2005),
- le traitement de la ou des valeurs de mesure dans une unité de traitement de données (2012) reliée au second appareil radio (2005) pour obtenir au moins une instruction de commande,
- la transmission de l'instruction ou des instructions de commande à l'actionneur (2006) par l'intermédiaire de la liaison radio présente au moins temporairement entre le second (2005) et le premier appareil radio (2004).

13. Procédé de commande d'un dispositif de chauffage (2501) dans une installation d'application de revêtement (2000), l'installation d'application de revêtement (2000) comprenant au moins une chambre d'application de revêtement (2001) et au moins un porte-substrat (2002) qui est conçu pour recevoir des substrats (2003) à revêtir et qui est monté mobile à l'intérieur de la chambre d'application de revêtement (2001), et comprenant
- un dispositif radio comportant au moins
-- un premier appareil radio (2004), lequel est relié au porte-substrat (2002), et
-- un second appareil radio (2005), lequel est disposé au moins en partie à l'extérieur de la chambre d'application de revêtement (2001),
ledit procédé comportant les étapes suivantes :
- l'enregistrement d'au moins une valeur de mesure au moyen d'un appareil de mesure (2701), lequel est relié au porte-substrat (2002),
- la transmission de la ou des valeurs de mesure par l'intermédiaire d'une liaison radio présente au moins temporairement entre le premier (2004) et le second appareil radio (2005),
- le traitement de la ou des valeurs de mesure dans une unité de traitement de données (2012) reliée au second appareil radio (2005) pour obtenir au moins une instruction de commande,
- la transmission de l'instruction ou des instructions de commande au dispositif de chauffage (2501) par l'intermédiaire de la liaison radio présente au moins temporairement entre le second (2005) et le premier appareil radio (2004).
